(19) **Europäisches Patentamt / European Patent Office / Office européen des brevets**

(11) **EP 1 786 032 A2**

(12) # EUROPEAN PATENT APPLICATION

(43) Date of publication:
**16.05.2007 Bulletin 2007/20**

(51) Int Cl.:
*H01L 21/683* $^{(2006.01)}$    *B29C 59/02* $^{(2006.01)}$

(21) Application number: **06023493.7**

(22) Date of filing: **11.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.11.2005  KR 20050108585**

(71) Applicant: **Sosul Industry Co., Ltd.**
**Gyeonggi-do (KR)**

(72) Inventor: **Chung, Seng-hyun**
**Yeongtong-gu**
**Suwon-si**
**Gyeonggi-do (KR)**

(74) Representative: **LOUIS, PÖHLAU, LOHRENTZ**
**Patentanwälte**
**Postfach 30 55**
**D-90014 Nürnberg (DE)**

(54) **Embossing chuck enabling wafer to be easily detached therefrom**

(57)    An embossing chuck has an embossing part protruding, in a uniform height, from an upper surface of a body on which the wafer is put on. When viewed from the above, an area of the embossing part is 5~30% for a total area of the body. According to the chuck, since most of the charges existing in the chuck are concentrated at the embossing part and escape through the embossing part, when the embossing part is provided, the electrostatic force attracting the wafer becomes weak, as compared to a case where the embossing part is not provided to the chuck. Therefore, it is possible to easily detach the wafer from the chuck.

## FIG. 2B

Description

## CROSS-REFERENCE TO RELATED APPLICATIONS

This application claims all benefits of Korean Patent Application No. 10-2005-108585 filed on November 14, 2005 in the Korean Intellectual Property Office, the disclosures of which are incorporated herein by reference.

## BACKGROUND OF THE INVENTION

### Field of the Invention

The present invention relates to an embossing chuck, and more specifically, to an embossing chuck enabling a wafer to be easily detached from the chuck after putting off the plasma.

### Description of the prior art

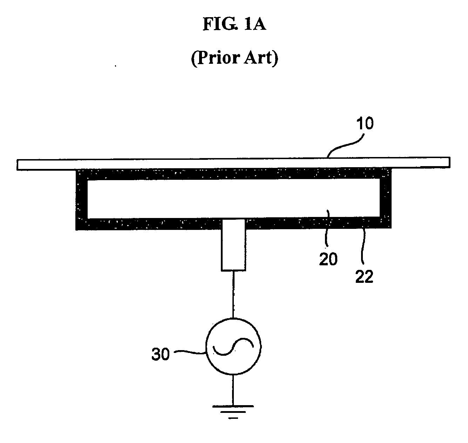

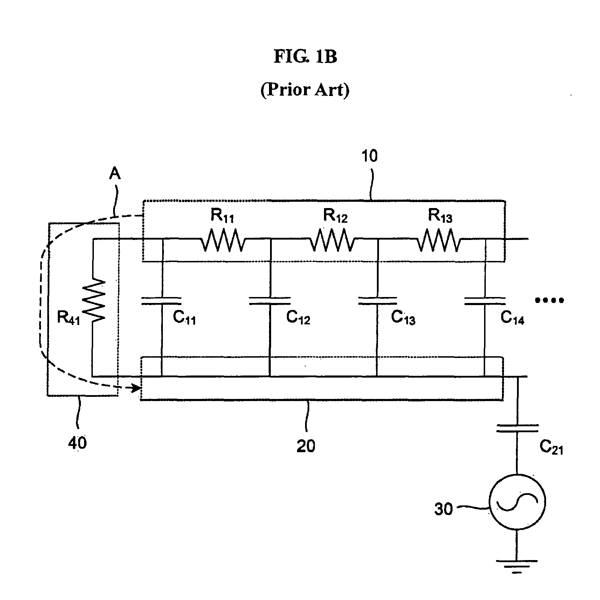

Even after putting off the plasma, there exists an electrostatic force between a wafer and a chuck. Accordingly, it is difficult to easily detach the wafer from the chuck. Figs. 1A and 1B illustrate a conventional wafer chuck 20, wherein Fig. 1A shows a detailed shape of the wafer chuck 20 and Fig. 1B shows an equivalent circuit of a case where a wafer 10 is put on the wafer chuck 20.
As shown in Fig. 1A, a body of the wafer chuck 20 on which the wafer 10 is put on consists of aluminum and a periphery of the body is anodized and is surrounded by a dielectric layer 22 made of alumina ($Al_2O_3$). Therefore, the wafer 10 is put on the dielectric layer 22.
Referring to Fig. 1B, when the plasma 40 is put off, the charges discharged to the wafer 10 through the plasma 40 escape from the wafer 10 to the chuck 20 along an arrow route (A). When the plasma 40 is completely put off, a resistance of the plasma 40 becomes infinite, so that the charges cannot flow. Accordingly, the flow of the charges as described above occurs for a short time until the plasma 40 is completely vanished. At this time, if the charges do not completely escape and remain at the wafer 10 due to surface resistances ($R11, R12, R13...$) of the wafer 10, the wafer 10 is not detached well from the chuck 20 due to the residual charge. The reference numerals C11, C12, C 13 and C 14 indicate capacitances between the chuck 20 and the wafer 10, and a reference numeral C21 indicates a capacitance between the chuck 20 and an external applying power 30.
As described above, when the conventional wafer chuck 20 is used, the charges accumulated on the wafer 10 cannot properly escape to the exterior due to a resistance ($R41$) of the plasma and the resistances ($R11, R12, ...$) of the wafer after the plasma 40 is put off, so that the wafer 10 is not detached well from the chuck 20. As a result, it is difficult to take out the wafer 10 having completed the process from a chamber.

## SUMMARY OF THE INVENTION

Accordingly, the present invention has been made to solve the above problems. An object of the invention is to provide an embossing chuck having an embossing part protruding from an upper surface of a body of the chuck so as to enable charges accumulated at a wafer to easily escape to an exterior after putting off the plasma.
In order to achieve the above object, there is provided an embossing chuck having an embossing part protruding, in a uniform height, from an upper surface of a body on which a wafer is put on, wherein an area of the embossing part is 5-30% for a total area of the body, viewed from the above.
The embossing part is preferably formed along an edge of the body. At this time, the embossing part may be discrete and thus consist of plural segments each of which having a predetermined length. For example, when the body is circular viewed from the above, the embossing part consists of plural segments having an arc shape along an edge of the body.
The embossing part preferably has a height of 0.05-0.5 mm.

## BRIEF DESCRIPTION OF THE DRAWINGS

The above and other objects, features and advantages of the present invention will be more apparent from the following detailed description taken in conjunction with the accompanying drawings, in which:

FIGs. 1A and 1B illustrate a conventional wafer chuck 20, wherein Fig. 1a shows a detailed shape of the wafer chuck 20 and Fig. 1b shows an equivalent circuit of a case where a wafer 10 is put on the wafer chuck 20;
FIGs. 2A and 2B illustrate an embossing chuck 20 according to an embodiment of the invention, wherein FIG. 2A is a plan view of an embossing chuck 120 and FIG. 2B is a sectional view of a case where a wafer 100 is put on the embossing chuck 120;

FIG. 3 is a circuit diagram for illustrating distribution of charges at an embossing chuck according to an embodiment of the invention; and

FIG. 4 is a view for illustrating another example of an embossing chuck 120 according to an embodiment of the invention.

## DETAILED DESCRIPTION OF THE PREFERRED EMBODIMENTS

Hereinafter, a preferred embodiment of the present invention will be described with reference to the accompanying drawings. In the following description of the present invention, a detailed description of known functions and configurations incorporated herein will be omitted when it may make the subject matter of the present invention rather unclear.

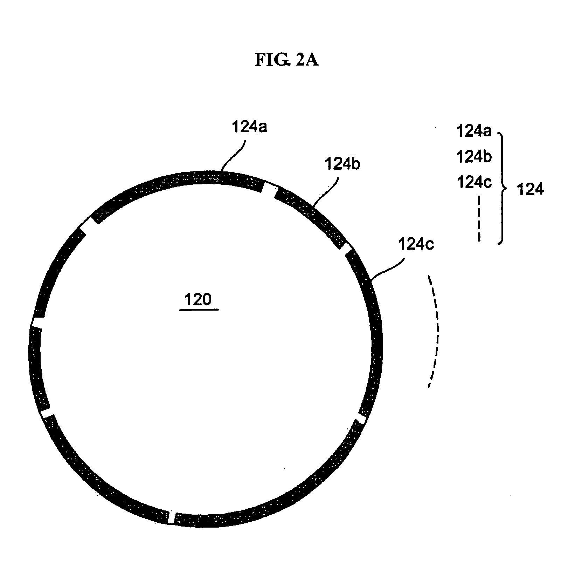

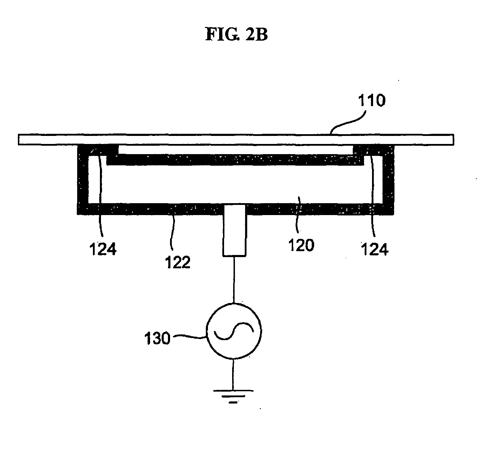

Figs. 2A and 2B illustrate an embossing chuck 20 according to an embodiment of the invention, wherein Fig. 2A is a plan view of an embossing chuck 120 and Fig. 2B is a sectional view of a case where a wafer 110 is put on the embossing chuck 120.

As shown in Fig. 2A, an embossing part 124 protruding, in a uniform height, from an upper surface of a body of an embossing chuck 120 is formed along an edge of the body. When viewed from the above, an area of the embossing part 124 is preferably 5-30% for a total area of the body. When the area of the embossing part 124 is excessively large, a contact area of a wafer to the chuck is substantially large, so that it is restored to the prior art. When the body of the chuck 120 is circular viewed from the above, the embossing part 124 may consist of plural segments 124a, 124b, ... each of which having an arc shape along the edge of the body of the chuck 120. However, the invention is not limited thereto. For example, the segments 124a, 124b, ... may be continuously connected to each other, thereby forming a single circle shape.

Referring to Fig. 2B, when the height of the embossing part 124 is too high, the plasma may be formed at a back surface of the wafer 100. Accordingly, it is preferable to make the height of the embossing part 124 0.05-0.5 mm so that it is not too high. The body of the embossing chuck 120 consists of a metal material such as aluminum and a dielectric layer 122 such as alumina is formed at a periphery thereof.

[distribution of charges]

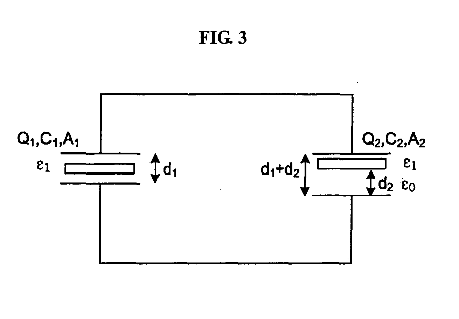

Fig. 3 is a circuit diagram for illustrating distribution of charges at an embossing chuck according to an embodiment of the invention.

Referring to Fig. 3, Q1, C1 and A1 are charge, capacitance and area of the embossing part 124 and Q2, C2 and A2 are charge, capacitance and area of a part in which the embossing part 124 is not provided. d1 is a vacuum thickness and d2 is a thickness of the dielectric layer 122. $\varepsilon 0$ is a vacuum permittivity and $\varepsilon 1$ is a permittivity of the dielectric layer 122.

Since the voltages applied to the embossing part 124 and the part in which the embossing part is not provided are same,

$$V = \frac{Q}{C} = \frac{Q1}{C1} = \frac{Q2}{C2} \ \text{------} \ (1)$$

$$C1 = \frac{\varepsilon 1 \cdot A1}{d1} \ \text{--------------} \ (2)$$

Since C2 can be assumed as a series connection of the dielectric layer 122 and a vacuum layer,

$$\frac{1}{C2} = \frac{1}{C(dielectric\ layer)} + \frac{1}{C(vacuum\ layer)}$$

therefore,

$$C2 = \cfrac{1}{\cfrac{1}{C(dielectric\ layer)} + \cfrac{1}{C(vacuum\ layer)}} \quad \text{------- (3)}$$

$$= \cfrac{1}{\cfrac{d1}{\varepsilon 1 \cdot A2} + \cfrac{d2}{\varepsilon 0 \cdot A2}}$$

When substituting the equations (2) and (3) for the equation (1),

$$V = \frac{Q1}{\varepsilon 1 \cdot A1} d1 = \frac{Q2}{\varepsilon 1 \cdot A2} d2 + \frac{Q2}{\varepsilon 0 \cdot A2} d2$$

As a result, it is obtained a following result

$$Q1\left(\frac{d1}{\varepsilon 1 \cdot A1}\right) = Q2\left(\frac{d1}{\varepsilon 1 \cdot A2} + \frac{d2}{\varepsilon 0 \cdot A2}\right) \quad \text{-------- (4)}$$

In the mean time,

$$Q = Q1 + Q2 \quad \text{------ (5)}$$

Accordingly, when substituting the equation (4) for the equation (5), it is obtained a following equation.

$$Q1 = \frac{\left(\dfrac{d1}{\varepsilon 1 \cdot A2}\right) + \left(\dfrac{d2}{\varepsilon 0 \cdot A2}\right)}{\dfrac{d1}{\varepsilon 1 \cdot A1} + \left(\dfrac{d1}{\varepsilon 1 \cdot A2} + \dfrac{d2}{\varepsilon 0 \cdot A2}\right)} \cdot Q \quad \text{---------- (6)}$$

Therefore,

when $A1 = \dfrac{6.8}{100} \cdot A$, $A2 = \dfrac{93.2}{100} \cdot A$, $\varepsilon 1 = 9 \cdot \varepsilon 0$

d1 = 0.05 mm and d2 = 1 mm,
Q1 = 0.9296Q.
In other words, Q1 is 93% of the overall Q and Q2 is 7% of the overall Q. This means that about 93% of the overall charge exists at the embossing part 124 and 7% of the charge exits at the part in which the embossing part is not provided.

[charge per unit area]

The charge per unit area in the embossing part 124 is as follows:

$$\frac{C1}{A1} = \frac{\varepsilon 1}{d1} = \frac{9 \cdot \varepsilon 0}{0.05 \ mm} \ \text{------------------} \ (7)$$

and the charge per unit area in which the embossing part 124 is not provided as follows: .

$$\frac{C2}{A2} = \frac{1}{\dfrac{d1}{\varepsilon 1} + \dfrac{d2}{\varepsilon 0}} = \frac{1}{\dfrac{0.05 \ mm}{9 \cdot \varepsilon 0} + \dfrac{1 \ mm}{\varepsilon 0}} \ \text{--------------} \ (8)$$

Accordingly,

$$\frac{(\dfrac{C1}{A1})}{(\dfrac{C2}{A2})} = 181 \ \text{------------------} \ (9)$$

When 93% of the overall charge is collected in the embossing part 124, the area of the embossing part 124 is only 6.8% of the overall area, but the capacitance (C1/A1) per unit area of the embossing part 124 is 181 times as large as the capacitance (C2/A2) per unit area of the part in which the embossing part is not provided.

[electrostatic force]

In case that the embossing part 124 is provided, it is assumed as follows: 93% of the overall charge first escapes through the embossing part 124 and the residual charge of 7% is redistributed to the embossing part 124, so that the charge of 6.5% (=7% × 93/100) is accumulated at the embossing part 124 and the charge of 0.5% (=7% × 7/100) is accumulated at the part in which the embossing part 124 is not provided. In this assumption, the force (F1) acting between the wafer 120 and the chuck 110 is as follows:

$$F1 = \frac{(0.065Q)^2}{2 \cdot \varepsilon 0 \cdot A1} + \frac{(0.005Q)^2}{2 \cdot \varepsilon 0 \cdot A2} = 0.062 \frac{Q^2}{2 \cdot \varepsilon 0 \cdot A} \ \text{------} \ (10)$$

In the mean time, in case that the embossing part 124 is not provided to the chuck, only the charge of 6.8% proportional to the area of the embossing part 124 first escapes, so that the charge of 93.2% remains. Accordingly, as shown in Fig. 1A, in case that the embossing part 124 is not provided to the chuck, the force (F2) acting between the wafer 20 and the chuck 10 is as follows:

$$F2 = \frac{(0.932Q)^2}{2 \cdot \varepsilon 0 \cdot A} = 0.869 \frac{Q^2}{2 \cdot \varepsilon 0 \cdot A} \ \text{--------} \ (11)$$

Therefore,

$$\frac{F1}{F2} \times 100 = 7.16\% \cong 7.2\% \ \text{------------------} \ (12)$$

In other words, as shown in Fig. 2B, the electrostatic force of the case where the embossing part 124 is provided is only about 7.2%, as compared to the electrostatic force of the case where the embossing part 124 is not provided as shown in Fig. 1A.

The result as described above is obtained on the assumption that the charge of 93% accumulated at the embossing part 124 first escapes completely. If all the charge accumulated at the embossing part 124 does not escape and only about 80% escapes and 20% remains, the overall charge remaining in the embossing chuck 120 is as follows:

$$0.93Q \times 0.2 + 0.07Q = 0.256Q \ \text{-------- (13)}$$

If such charge is redistributed, the following charge is accumulated at the embossing part 124:

$$0.256Q \times \frac{93}{100} = 0.238Q$$

and the following charge is accumulated at the part in which the embossing part 124 is not provided:

$$0.256Q \times \frac{7}{100} = 0.0179Q$$

Accordingly, in this case, the electrostatic force (F1') is as follows:

$$F1' = \frac{(0.238Q)^2}{2 \cdot \varepsilon 0 \cdot (0.068A)} + \frac{(0.0179Q)^2}{2 \cdot \varepsilon 0 \cdot (0.932A)} \ \text{-------- (14)}$$
$$= 0.834 \frac{Q^2}{2 \cdot \varepsilon 0 \cdot A}$$

This force corresponds to $\frac{0.834}{0.869} \times 100 = 96\%$ with respect to the electrostatic force (F2) (refer to the equation 11) of the case where the embossing part is not provided to the chuck. Accordingly, if the charge of 20% or more accumulated at the embossing part 124 cannot escape, it is difficult to expect that the wafer would be easily detached, which is the desired effect of the invention. Since the amount of the charge escaping from the embossing part 124 depends on various factors such as types of the plasma, pressure, materials of the electrostatic chuck, it is required to control the factors, too.

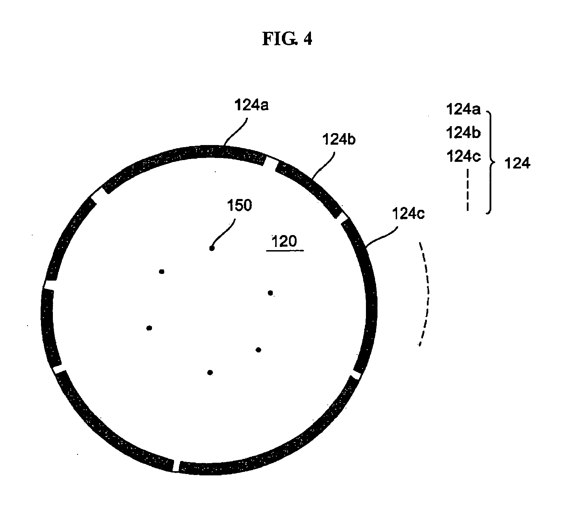

Fig. 4 is a view for illustrating another example of an embossing chuck 120 according to an embodiment of the invention. Since only the edge of the wafer 110 is supported by the embossing part 124, a center part of the wafer 100 may be sagged down when the wafer 110 is large. Accordingly, it is preferable to additionally provide embossing parts 150 for supporting the wafer in a circle pattern.

As described above, according to the invention, since most of the charges existing in the chuck are concentrated at the embossing part 124 and escape through the embossing part, when the embossing part 124 is provided, the electrostatic force attracting the wafer 110 becomes weak, as compared to a case where the embossing part 124 is not provided to the chuck. Therefore, it is possible to easily detach the wafer 110 from the chuck 120.

While the invention has been shown and described with reference to certain preferred embodiments thereof, it will be understood by those skilled in the art that various changes in form and details may be made thereto without departing from the spirit and scope of the invention as defmed by the appended claims.

**Claims**

1. An embossing chuck(120) having an embossing part(124) protruding, in a uniform height, from an upper surface of a body on which a wafer(110) is put on, wherein an area of the embossing part(124) is 5-30% for a total area of the body, viewed from the above.

2. The embossing chuck(120) according to claim 1, wherein the embossing part(124) is formed along an edge of the body.

3. The embossing chuck(120) according to claim 2, wherein the embossing part(124) is discrete and consists of plural segments(124a, 124b,...) each of which having a predetermined length.

4. The embossing chuck(120) according to claim 2, wherein when the body is circular viewed from the above, the embossing part(124) consists of plural segments(124a, 124b,...) having an arc shape along an edge of the body.

5. The embossing chuck(120) according to claim 1, wherein the body consists of a metal material and a dielectric layer (122) is formed on the upper surface thereof.

6. The embossing chuck(120) according to claim 5, wherein the metal material is aluminum and the dielectric layer (122) is alumina.

7. The embossing chuck(120) according to claim 1, wherein the embossing part(124) has a height of 0.05~0.5 mm.

FIG. 1A

(Prior Art)

## FIG. 1B

## (Prior Art)

FIG. 2A

**FIG. 2B**

FIG. 3

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 102005108585